(19) Europäisches Patentamt
European Patent Office
Office européen des brevets

(11) Veröffentlichungsnummer: **0 031 967**
**B1**

(12) **EUROPÄISCHE PATENTSCHRIFT**

(45) Veröffentlichungstag der Patentschrift: **03.04.85**

(51) Int. Cl.⁴: **C 08 L 65/02,** H 01 B 1/12, H 01 L 29/28, H 01 L 31/02

(21) Anmeldenummer: **80108251.2**

(22) Anmeldetag: **30.12.80**

# (54) Verfahren zur Herstellung von elektrisch leitfähigen Polyaromaten und deren Verwendung in der Elektrotechnik und zur antistatischen Ausrüstung von Kunststoffen.

(30) Priorität: **07.01.80 DE 3000379**

(43) Veröffentlichungstag der Anmeldung:
**15.07.81 Patentblatt 81/28**

(45) Bekanntmachung des Hinweises auf die Patenterteilung:
**03.04.85 Patentblatt 85/14**

(84) Benannte Vertragsstaaten:
**AT BE CH DE FR GB LI NL**

(56) Entgegenhaltungen:
**EP-A-0 016 305**
**GB-A-1 000 679**
**US-A-4 025 463**
**Extended Abstracts, Band 80, Mai 1980 Princeton R.R. CHANCE et al. "Conducting Charge-Transfer Complexes of Poly(p-Phenylene)" Abstract Nr. 65, Seiten 180, 181**

**Die Akte enthält technische Angaben, die nach dem Eingang der Anmeldung eingereicht wurden und die nicht in dieser Patentschrift enthalten sind.**

(73) Patentinhaber: **BASF Aktiengesellschaft**
**Carl-Bosch-Strasse 38**
**D-6700 Ludwigshafen (DE)**

(72) Erfinder: **Naarmann, Herbert, Dr. Chem.**
**Haardtblick 15**
**D-6719 Wattenheim (DE)**
Erfinder: **Naegele, Dieter, Dr. Chem.**
**Obere Jakobstrasse 8**
**D-6520 Worms (DE)**
Erfinder: **Penzien, Klaus, Dr. Chem.**
**Bensheimer Ring 18**
**D-6710 Frankenthal (DE)**
Erfinder: **Schlag, Johannes, Dr. Phys.**
**Leuschnerstrasse 36**
**D-6700 Ludwigshafen (DE)**

(56) Entgegenhaltungen:
**JOURNAL OF CHEMICAL PHYSICS, Band 71, Nr. 3, 1979 D.M. IVORY et al. "Highly Conducting Charge-Transfer Complexes of Poly(p-Phenylene)" Seiten 1506, 1507**

**H. MEIER "Organic Semiconductors" 1974, VERLAG CHEMIE, Weinheim**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

EP 0 031 967 B1

**Beschreibung**

Die Erfindung betrifft ein Verfahren zur Herstellung von elektrisch leitfähigen Polyaromaten mit elektrischen Leitfähigkeitswerten größer als $10^{-2}$ S/cm und deren Verwendung in der Elektroindustrie sowie zur antistatischen Ausrüstung von Kunststoffen.

Es ist bereits bekannt, Polyaromate durch oxidative Kupplung entsprechend der Literatur: "Macromolecular Syntheses Collective", Vol. 1, (1979) Seiten 109 bis 110, Verlag John Wiley & Sons und "Naturwissenschaften" *56* (1969) Seiten 308 bis 313 herzustellen. Außerdem ist die Herstellung von Polyaromaten durch stufenweise Polykondensation nach R. Gehm und W. Kern aus "Makromolekulare Chemie" *7* (1951) Seiten 46—61 bekannt, wobei besonders einheitliche, para-verkettete methylsubstituierte Derivate erhalten werden, die nicht zusätzlich durch ortho- oder meta-vernüpfte Polymere verunreinigt sind.

Der Erfindung lag die Aufgabe zugrunde, die an sich bekannten Polyaromaten durch Zusätze in elektrisch leitfähige Polymere mit elektrischen Leitfähigkeiten größer als $10^{-2}$ S/cm umzuwandeln.

Diese Aufgabe wurde erfindungsgemäß dadurch gelöst, daß man den Polyaromaten der allgemeinen Formel

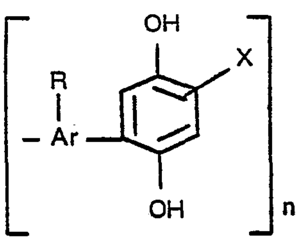

worin n = 1 bis 50 ist un X = Ar—R, Ar ist ein aromatisches System, R = H oder eine aliphatische, cycloaliphatische, aromatische oder eine funktionelle Gruppe sein kann, unter Ausschluß von Wasserfeuchtigkeit 0,5 bis 15 Gew.-%, bezogen auf den eingesetzten Polyaromaten, an Lewis-Säuren sowie deren $NO^+$— oder $NO_2^+$—Salze, ferner Nitroaromaten, Trinitrosulfonsäure und/oder Fluorderivate oder auch Säuren zugesetzt werden. Nach bevorzugter Verfahrensweise werden die Lewis-Säuren in Tetrahydrofuran, Dimethoxyglykol, Anthrazen, Naphthalin oder 2-Methylstyrol, jeweils im Molverhältnis 1:1 bis 1:50, vorzugsweise 1:2 bis 1:3, zugesetzt.

Die Polyaromaten der allgemeinen Formel sind an sich bekannte höhermolekulare Produkte, deren Ketten vollständig aus aneinander gekoppelten, gegebenenfalls Substituenten R tragendenden Aromat-systemen gemäß der allgemeinen Formel bestehen, und die durch Friedel-Crafts-Reaktion unter dehydrierenden Bedingungen sowie andere Verfahren der Dehydrierung bzw. oxidativen Kupplung aus Benzol bzw. substituierten Benzolen mit Benzochinon oder Derivaten und anschließende Reduktion erhalten werden. Bevorzugt sind die Polyaromaten mit einer linearen Verknüpfung der aromatischen Systeme. Die Polyaromaten weisen ein Molekulargewicht von 200 bis 5000 auf. Ar ist vorzugsweise Phenylen, die funktionelle Gruppe kann z.B. CN oder

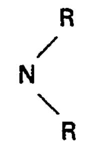

sein. Die Herstellung der Polyaromaten kann nach der eingangs zitierten Literatur erfolgen.

Die elektrischen Leitfähigkeitswerte werden in S/cm bei 30°C gemessen, die Messung selbst erfolgt nach der Methode von F. Beck, "Berichte Bunsengesellschaft, Physikalische Chemie" *68* (1964) Seiten 558 bis 567. Die elektrischen Leitfähigkeitswerte der erfindungsgemäßen leitfähigen Polyaromaten sind größer als $10^{-2}$ S/cm. Die Herstellung der Polyaromaten kann auch nach P.R. Schildneck et al, J. Amer. Chem. Soc. *53* (1931), Seite 2373 erfolgen.

Nach dem erfindungsgemäßen Verfahren wird den Polyaromaten unter Ausschluß von Wasserfeuchtigkeit 0,5 bis 15 Gew.%, bezogen auf den eingesetzten Polyaromaten, an Lewis-Säuren, wie Antimon- oder Arsenpentafluorid sowie deren $NO^+$- oder $NO_2^+$-Salze, ferner Nitroaromate wie Trinitrophenol, Trinitrosulfonsäure, und/oder Fluorderivate wie $CF_3$—COOH oder auch Säuren wie Schwefelsäure, Salpetersäure oder Überchlorsäure zugesetzt.

Das Einarbeiten der Zusätze erfolgt unter Ausschluß von Feuchtigkeit (Wasser), es wird vorzugsweise unter Argonmosphäre gearbeitet. Vorzugsweise werden Hilfsflüssigkeiten wie Tetrahydrofuran, Nitromethan oder $CCl_4$ oder $CHCl_3$, jeweils im Molverhältnis 1:1 bis 1:50 eingesetzt, die nach dem Einarbeiten bei Temperaturen unter 30°C im Vakuum abgezogen werden. Das obige Molverhältnis ist bevorzugt 1:2 bis 1:3.

Durch die genannten Zusätze können elektrische Leitfähigkeitsanstiege von einigen Größenordnungen erreicht werden. Die Ausgangsleitfähigkeiten der nach der oxidativen Kupplungsmethode hergestellten Polyaromaten betrugen ca. $10^{-12}$ bis $10^{-8}$ S/cm. Die nach der stufenweisen Kondensation hergestellten Polyaromaten haben Ausgangsleitfähigkeiten von weniger als $10^{-12}$ S/cm, liefern aber nach der Zugabe der erfindungsgemäßen Zusätze Leitfähigkeiten von mindestens $10^{-2}$ S/cm.

Die erfindungsgemäß hergestellten elektrisch leitfähigen Polyaromaten mit elektrischen Leitfähigkeiten von mindestens $10^{-2}$ S/cm sind zur antistatischen Ausrüstung von Kunststoffen, zur Herstellung von Sonnenzellen, zur Umwandlung und Fixierung von Strahlung sowie zur Herstellung elektrischer und magnetischer Schalter geeignet. Durch die Zsätze der starken Lewis-Säure zum Polyaromaten entstehen sog. p-Leiter.

Die in den folgenden Beispielen genannten Teile sind Gewichtsteile. Die Angabe der Gliederzahl n (Kettenlänge der Polyaromaten) erfolgt durch Endgruppenanalyse über IR—Bestimmung des Verhältnisses der monofunktionellen Endgruppe zur difunktionellen Mittelgruppe.

Beispiele 1 bis 6

10 Teile eines Polyaromaten werden unter Argonatmosphäre und Ausschluß von Feuchtigkeit mit dem jeweiligen Zusatzmittel versetzt, die Messung der elektr. Leitfähigkeit erfolgt nach F. Beck, "Ber. Bunsengesellschaft, Phys. Chem." *68,* 558 bis 567 (1964).

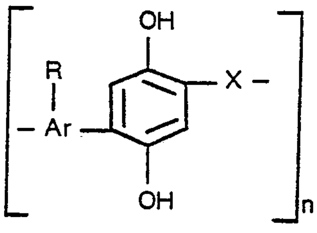

| Nr. | Polyaromat Type und Menge | | | Dopingmittel Art und Menge | | Leitfähigkeit S/cm 30°C vor d. Dopen, | nach dem Dopen |
|---|---|---|---|---|---|---|---|
| 1 | 10 Teile, n ca. | 3 | (2) | $SbF_5$ | 1,0 | $10^{-5}$ | $2{,}9 \cdot 10^{-2}$ |
| 2 | 10 Teile, n ca. | 5 | (2) | $SbF_5$ | 1,5 | ,, | $3{,}2 \cdot 10^{-2}$ |
| 3 | 10 Teile, n ca. | 15 | (2) | $NO^{+5}SbF_6$ | 1,5 | $10^{-6}$ | $1{,}9 \cdot 10^{-1}$ |
| 4 | +10 Teile, n ca. | 10 | (2) | $H_2SO_4$ | 1,0 | $10^{-6}$ | $1{,}4 \cdot 10^{-2}$ |
| 5 | ++10 Teile, n ca. | 20 | (2) | $CF_3COOH$ | 1,5 | $10^{-6}$ | $3{,}6 \cdot 10^{-2}$ |
| Vgl. | 10 Teile, n = ca. (Polyphenylene) | 3 | (1) | $SbF_5$ | 1,0 | $10^{-12}$ | $7{,}1 \cdot 10^{-1}$ |
| 6 | 10 Teile, n = 1 | | (2a) | | 1,0 | $10^{-5}$ | $10^{-2}$ |

1) bedeutet: nach der Methode R. Gehm et. al. Makromolekulare Chemie 7, (1951) Seiten 46 bis 61.

2) bedeutet: nach der Methode (2a) Lit. J. Amer. Chem. Soc. *53* (1931)), Seite 2373 und anschließende oxidative Kupplung nach Macromolekulare Synthesis Collective Vol. *1* (1979) Seiten 109 bis 110.

+) bedeutet: 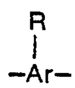 enspr. 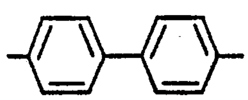 (Beispiel 4)

++) bedeutet: 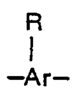 entspr. 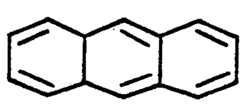 (Beispiel 5)

In den Beispielen 1 bis 6 bedeutet x = 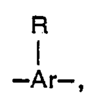,

in den Beispielen 1 bis 3 und 6 is 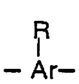 = 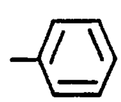

**Patentansprüche**

1. Verfahren zur Herstellung von elektrisch leitfähigen Polyaromaten mit elektrischen Leitfähigkeitswerten größer als $10^{-2}$ S/cm *dadurch gekennzeichnet*, daß den Polyaromaten der allgemeinen Formel:

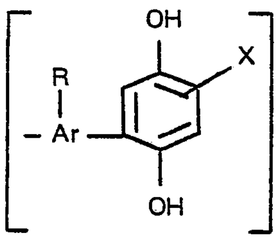

worin n = 1 bis 50 ist und X = Ar—R, Ar ein aromatisches System, R = H oder eine aliphatische, cycloaliphatische, aromatische oder eine funktionelle Gruppe sein kann unter Ausschluß von Wasserfeuchtigkeit 0,5 bis 15 Gew.-%, bezogen auf den eingesetzten Polyaromaten, an Lewis-Säuren sowie deren $NO^+$- oder $NO_2^+$-Salze, ferner Nitroaromate, Trinitrosulfonsäure und/oder Fluorderivate oder auch Säuren zugesetzt werden.

2. Verwendung der nach Anspruch 1 hergestellten leitfähigen Polyaromaten in der Elektrotechnik zur Herstellung von Sonnenzellen, zur Umwandlung und Fixierung von Strahlung und zur Herstellung elektrischer und magnetischer Schalter.

3. Verwendung der nach Anspruch 1 hergestellten leitfähigen Polyaromaten zur antistatischen Ausrüstung von Kunststoffen.

**Revendications**

1. Procédé pour la préparation de polycarbures aromatiques électriquement conducteurs, ayant des valeurs de conductibilité électrique de plus de $10^{-2}$ S/cm, caractérisé en ce qu'aux polycarbures aromatiques de formule générale

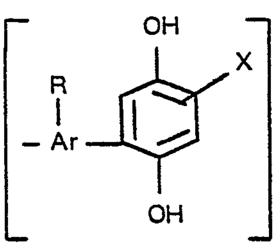

dans laquelle n = 1 à 50 et X = Ar — R, Ar est un système aromatique, R = H ou peut être un groupe aliphatique, cycloaliphatique, aromatique ou un groupe fonctionnel, on ajoute, à l'abri de l'humidité aqueuse, 0,5 à 15% en poids, par rapport au polycarbure aromatique mis en réaction, d'acides de Lewis ou de leurs sels de $NO^+$ ou $NO_2^+$, de carbures nitroaromatiques, d'acide trinitrosulfonique et/ou de dérivés fluorés ou même d'acides.

2. Utilisation des polycarbures aromatiques préparés suivant la revendication 1 dans l'électrotechnique pour la fabrication de piles solaires, pour la transformation et la fixation de rayonnement et pour la fabrication de commutateurs électriques et magnétiques.

3. Utilisation des polycarbures aromatiques préparés suivant la revendication 1 pour l'apprêt antistatique de matières synthétiques.

**Claims**

1. A process for the production of electrically conductive polyaromatics having conductivities of more than $10^{-2}$ S/cm, wherein there is added to the polyaromatics of the general formula

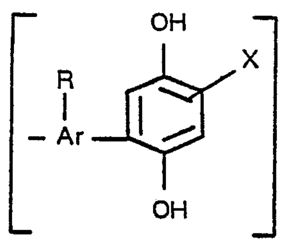

where n is from 1 to 50, X is Ar-R, Ar is an aromatic system, R is H or an aliphatic, cycloaliphatic or aromatic group or a functional group, in the absence of moisture, from 0.5 to 15% by weight, based on the polyaromatic employed, of a Lewis acid, an $NO^+$- or $NO^+$-salt thereof, a nitroaromatic, trinitrosulfonic acid and/or a fluorine derivative or an acid.

2. The use of the conductive polyaromatics, produced according to claim 1, in electrical engineering for the production of solar cells, for the conversion and fixation of radiation and for the production of electrical and magnetic switches.

3. The use of the conductive polyaromatics, produced according to claim 1, for the antistatic finishing of plastics.